(19) Europäisches Patentamt
European Patent Office
Office européen des brevets

(11) **EP 3 605 004 B1**

(12) **EUROPEAN PATENT SPECIFICATION**

(45) Date of publication and mention
of the grant of the patent:
**06.04.2022 Bulletin 2022/14**

(21) Application number: **19188695.1**

(22) Date of filing: **26.07.2019**

(51) International Patent Classification (IPC):
**F28F 13/00** *(2006.01)*      **F28D 15/04** *(2006.01)*
**F28D 15/02** *(2006.01)*      **F28D 21/00** *(2006.01)*

(52) Cooperative Patent Classification (CPC):
**F28F 13/003; F28D 15/0266; F28D 15/043;
F28D 15/046;** F28D 2021/0029

(54) **WICK, LOOP HEAT PIPE, COOLING DEVICE, ELECTRONIC DEVICE**

DOCHT, SCHLAUFENWÄRMEROHR, KÜHLVORRICHTUNG, ELEKTRONISCHE VORRICHTUNG

MÈCHE, CALODUC EN BOUCLE, DISPOSITIF DE REFROIDISSEMENT, DISPOSITIF ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.07.2018 JP 2018142655**

(43) Date of publication of application:
**05.02.2020 Bulletin 2020/06**

(73) Proprietor: **Ricoh Company, Ltd.**
**Tokyo 143-8555 (JP)**

(72) Inventors:
• **ENDOH, Takeshi**
**Tokyo 143-8555 (JP)**
• **TANAKA, Takashi**
**Tokyo 143-8555 (JP)**
• **MOKI, Akihiko**
**Tokyo 143-8555 (JP)**
• **HIRAI, Atsuo**
**Atsugi City 243-0298 (JP)**

(74) Representative: **J A Kemp LLP**
**80 Turnmill Street**
**London EC1M 5QU (GB)**

(56) References cited:
EP-A1- 3 343 161      CN-A- 105 928 403
JP-A- H09 119 789      JP-A- 2003 148 887
US-A1- 2010 294 475      US-A1- 2012 279 068

**Description**

BACKGROUND

Technical Field

The present invention relates to a wick, a loop heat pipe, a cooling device, and an electronic device.

Related Art

Conventionally, there is known a wick configured by a porous body used in a cooler such as a loop heat pipe including an evaporator that changes a working fluid from a liquid phase to a gas phase and a condenser that changes the working fluid from the gas phase to the liquid phase, and provided inside the evaporator.

For example, JP2018-109497-A describes a configuration in which the following wick is provided inside an evaporator of a loop heat pipe.

The wick is a cylindrical hollow member configured by porous rubber and closed at one end side, and has a plurality of grooves formed in a direction perpendicular to a circumferential direction of an outer peripheral surface in contact with a casing of the evaporator, the grooves transporting a working fluid changed in a gas phase. This wick is provided inside the evaporator. Specifically, the wick larger than an inner diameter of a cylindrical internal space of the casing of the evaporator that includes the wick is pressed into the casing of the evaporator.

Further, specifications (specification and conditions at the time of manufacturing) of a porous bubble structure of the porous rubber configuring this wick are favorably an average pore diameter of 50 $\mu$m or smaller, porosity of from 20 to 80%, both inclusive, and a continuous foam rate of from 25 to 100%, both inclusive.

With these configurations, securement of adhesion of the wick to an inner surface of a casing of the evaporator and suppression of local collapse of holes in the vicinity of an outer peripheral surface of the wick can be easily performed, and favorable cooling performance can be obtained. A wick according to the preamble of claim 1 is known from JP2003-148887-A.

SUMMARY

However, in recent years, the demand for further improvement of the cooling performance of the cooler used for electronic devices and the like has increased more than before.

According to the invention, there is provided a wick that includes a porous body. The porous body includes a plurality of bubbles, a plurality of composite cells, and a plurality of communication holes. The plurality of bubbles has sizes in a range from 0.1 $\mu$m to 50 $\mu$m, both inclusive, in a cross section obtained when the porous body is cut. The plurality of composite cells is formed by spherical bubbles partially overlapping each other. Bubbles of pore sizes from 5 $\mu$m to 10 $\mu$m, both inclusive, are most present among the plurality of composite cells. The plurality of communication holes of 5 $\mu$m or smaller are between the plurality of bubbles.

In another aspect of the present invention, there is provided a loop heat pipe that includes an evaporator, a condenser, and the wick. The evaporator is configured to change a working fluid from a liquid phase to a gas phase. The condenser is configured to change the working fluid from the gas phase to the liquid phase. The wick is disposed inside the evaporator.

In still another aspect of the present invention, there is provided a cooling device that includes the loop heat pipe.

In still yet another aspect of the present disclosure, there is provided an electronic device that includes the loop heat pipe as a cooler.

According to the present invention, the wick enabling implementation of further improvement of the cooling performance of the cooler can be provided.

BRIEF DESCRIPTION OF THE DRAWINGS

The aforementioned and other aspects, features, and advantages of the present disclosure would be better understood by reference to the following detailed description when considered in connection with the accompanying drawings, wherein:

FIG. 1 is a schematic explanatory view illustrating an example of a loop heat pipe according to an embodiment;
FIG. 2 is a view illustrating a virtual cross section when cut along the a-a section illustrated by the broken line in FIG. 1;
FIG. 3 is a schematic explanatory view of a conventional general loop heat pipe;
FIG. 4 is a schematic explanatory view illustrating another example of the loop heat pipe provided in an electronic device according to the embodiment;

FIG. 5 is an explanatory diagram of specifications and test results of samples of examples and comparative examples used for cooling performance test;

FIG. 6 is a view of a bubble state of a sample of a wick of Example 1 observed by a laser microscope;

FIG. 7 is a view of bubbles of the sample of the wick of Example 1 further enlarged and observed by a scanning electron microscope; and

FIG. 8 is a graph illustrating pore size distribution of representative samples of wicks used for examples and comparative examples used for cooling performance test.

The accompanying drawings are intended to depict embodiments of the present disclosure and should not be interpreted to limit the scope thereof. The accompanying drawings are not to be considered as drawn to scale unless explicitly noted.

DETAILED DESCRIPTION

In describing embodiments illustrated in the drawings, specific terminology is employed for the sake of clarity. However, the disclosure of this patent specification is not intended to be limited to the specific terminology so selected and it is to be understood that each specific element includes all technical equivalents that operate in a similar manner and achieve similar results.

Although the embodiments are described with technical limitations with reference to the attached drawings, such description is not intended to limit the scope of the disclosure and all of the components or elements described in the embodiments of this disclosure are not necessarily indispensable.

Referring now to the drawings, embodiments of the present disclosure are described below. In the drawings for explaining the following embodiments, the same reference codes are allocated to elements (members or components) having the same function or shape and redundant descriptions thereof are omitted below.

Hereinafter, an embodiment of a loop heat pipe (hereinafter referred to as loop heat pipe 1) will be described using drawings as appropriate, as a cooler including an evaporator provided with a wick to which the present invention is applied in an inside and a condenser.

Here, in the drawings for describing the present embodiment, description of constituent elements such as members or constituent parts having the same function or shape are provided with the same reference numerals as long as the constituent elements are distinguishable. Further, after once described, description of the constituent elements provided with the same reference numerals is appropriately omitted.

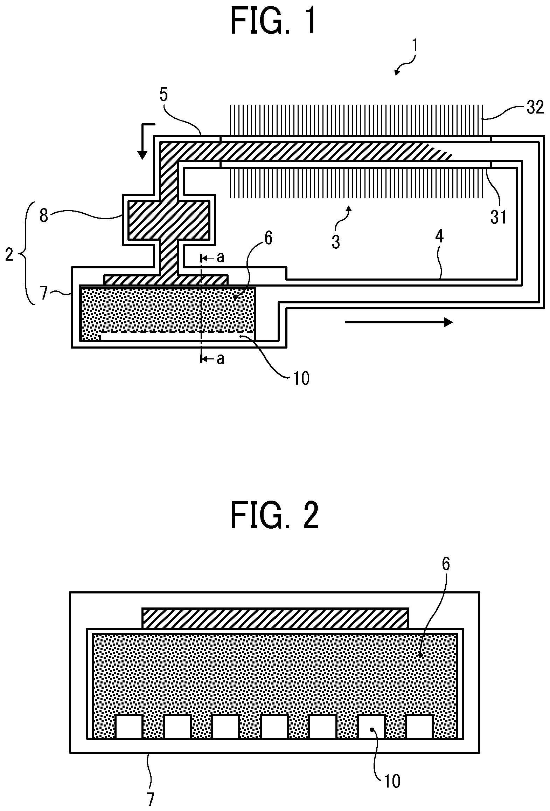

FIG. 1 is a schematic explanatory view illustrating an example of the loop heat pipe 1 according to the present embodiment, and FIG. 2 is a view illustrating a virtual cross section when cut along the a-a section illustrated by the broken line in FIG. 1.

The loop heat pipe 1 illustrated in FIG. 1 is filled with a working fluid containing a condensable fluid such as water, alcohol, acetone, or chlorofluorocarbon, and is provided with the following elements. The loop heat pipe 1 includes an evaporator 2 that absorbs heat from a heat generator and evaporates the working fluid from a liquid phase to a gas phase, and a condenser 3 that condenses the working fluid in the gas phase led from the evaporator 2 to the liquid phase. Further, the loop heat pipe 1 also includes a steam pipe 4 for circulating the working fluid in the gas phase from the evaporator 2 to the condenser 3 and a liquid pipe 5 for circulating the working fluid in the liquid phase from the condenser 3 to the evaporator 2. The evaporator 2 is configured by a heat receiver 7 in which a wick 6 is accommodated and a reservoir 8 that stores the working fluid in the liquid phase.

One end portion of the steam pipe 4 is coupled to the heat receiver 7, and one end portion of the liquid pipe 5 is coupled to the reservoir 8. Further, the other end portions of the steam pipe 4 and the liquid pipe 5 are coupled to the condenser 3. The condenser 3 is configured by a stainless-made pipe 31 provided with a large number of thin-plate aluminum-made fins 32 on an outer peripheral surface.

The wick 6 is a porous body having elasticity. Further, a plurality of grooves 10 is provided in a bottom surface in FIG. 1 of the wick 6 from an end portion on the steam pipe 4 side in a direction toward an opposite side.

The plurality of grooves 10 is provided at equal intervals in the bottom portion of the wick 6 as illustrated in FIG. 2 illustrating a virtual cross section when cut along the a-a section illustrated by the broken line in FIG. 1. Here, in FIG. 2, the dimensions of the groove 10 are drawn at a ratio larger than an actual size. Further, the thickness of the wick 6 is set to a size slightly larger than an inner size of a casing of the heat receiver 7 of the evaporator 2.

By setting the thickness of the wick 6 as described above, the wick 6 is in close contact with an inner surface of the heat receiver 7 in a state where the wick 6 is accommodated in the heat receiver 7. Further, since the wick 6 is in close contact with the heat receiver 7, the heat of the heat generator is efficiently transmitted to the wick 6 through the casing of the heat receiver 7. Meanwhile, in a portion where the groove 10 is provided, a space is formed between the portion and the casing of the heat receiver 7.

Since the wick 6 is configured by a porous body, that is, a porous material, the working fluid in the liquid phase stored in the reservoir 8 permeates into the wick 6 by a capillary phenomenon. Due to this capillary phenomenon, the wick 6 also plays a role of a pump for sending the working fluid in the liquid phase from the condenser 3 to the evaporator 2.

As the working fluid, a condensable fluid such as water, alcohol, acetone, or chlorofluorocarbon is used. Further, the working fluid favorably has good wettability with the wick 6 so as to be able to permeate into the wick 6. The wettability can be measured by a contact angle between the wick 6 and the working fluid. Since the working fluid cannot permeate into the wick 6 if the contact angle is 90° or higher, the contact angle needs to be less than 90°.

In the loop heat pipe 1 according to the present embodiment, when the heat from the heat generator is transmitted to the working fluid in the liquid phase in the wick 6 through the casing of the evaporator 2 (the heat receiver 7), the working fluid evaporates and changes to the gas phase by the heat. The working fluid that has evaporated and changed to the gas phase is sent to the steam pipe 4 through the grooves 10. Then, the working fluid in the gas phase is sent to the condenser 3 through the steam pipe 4.

In the condenser 3, the heat of the working fluid passing through the inside (pipe 31) is released to the outside through the fins 32, so that the temperature of the working fluid is lowered, and the working fluid is condensed and changes from the gas phase to the liquid phase. The working fluid that has changed to the liquid phase moves to the evaporator 2 through the liquid pipe 5, and permeates again from the reservoir 8 into the wick 6 provided inside the heat receiver 7 by the capillary phenomenon. By such circulation of the working fluid, the heat of the heat generator is continuously released to the outside, and an object to be cooled is cooled.

Here, disadvantage of a conventional loop heat pipe provided with a wick inside an evaporator will be described with reference to the drawing.

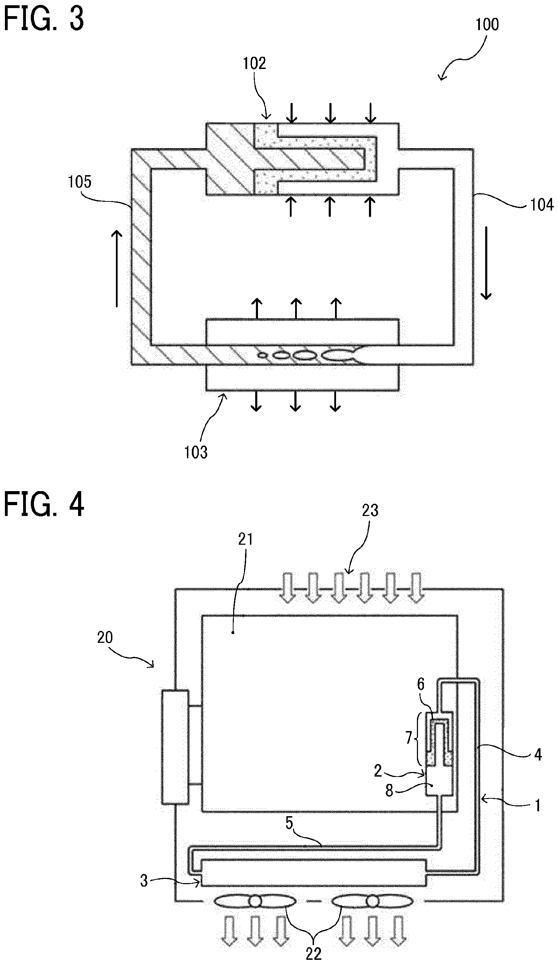

FIG. 3 is a schematic explanatory view of a conventional general loop heat pipe 100.

Generally, as illustrated in FIG. 3, the loop heat pipe 100 includes an evaporator 102 that receives heat from an outside and evaporates a working fluid from a liquid phase to a gas phase, and a condenser 103 that radiates heat to the outside to condense the working fluid from the gas phase to the liquid phase. Further, the loop heat pipe 100 also includes a steam pipe 104 for circulating the working fluid in the gas phase from the evaporator 102 to the condenser 103 and a liquid pipe 105 for circulating the working fluid in the liquid phase from the condenser 103 to the evaporator 102.

A wick 106 configured by a porous body (porous material) is accommodated inside the evaporator 102, and the working fluid in the liquid phase sent from the liquid pipe 105 permeate in fine holes in the wick 106 by the capillary phenomenon to bleed out to an outer surface of the wick 106. At this time, the heat from a heat generator (object to be cooled) in contact with the evaporator 102 is transmitted to the wick 106 through a casing of the evaporator 102, so that the working fluid evaporates by the heat and changes to the gas phase. Then, the working fluid that has changed to the gas phase moves to the condenser 103 through the steam pipe 104.

In the condenser 103, the heat of the working fluid is released to the outside, so that the temperature of the working fluid is decreased and changed to the liquid phase. Then, the working fluid that has changed to the liquid phase moves to the evaporator 102 through the liquid pipe 105 and again permeates into the wick 106. As described above, the loop heat pipe 100 circulates the working fluid using the phase change of the working fluid to transfer the heat absorbed in the evaporator 102 to the condenser 103, thereby efficiently cooling the object to be cooled.

Here, to improve cooling efficiency, adhesion with the evaporator 102 needs to be secured and the working fluid is circulated by the capillary force of the wick 106, and to minimize a pressure loss, the wick 106 is required to have high permeability.

To solve such problems, JP2011-247462-A (JP5699452-B) describes a loop heat pipe in which a metal pattern is formed on an outer surface of a wick and the metal pattern and an inner wall of a casing of an evaporator is diffusion-bonded to integrate the wick and the casing, and occurrence of gaps between joint surfaces is prevented by thermal or mechanical stress.

Further, configuring the wick with a resin material and making an outer diameter of the wick slightly larger than an inner diameter of the casing is a common method for ensuring favorable adhesion of the wick to the casing. However, if the outer diameter of the wick becomes excessively large due to a manufacturing error, when the wick is accommodated in the casing and compressed, a hole in a vicinity of the outer surface of the wick collapses, so that the flow of the working fluid may be impeded and cooling performance may be reduced. To solve the problem, JP2011-190996-A describes the following loop heat pipe.

A inner groove extending in a length direction is formed in an inner surface of a wick, in addition to an outer groove formed in an outer surface of the wick. Then, when the wick is pressed into and accommodated in a casing of an evaporator and deformed to close the inner groove, collapse of a hole in a vicinity of an outer peripheral surface is suppressed even if a manufacturing error occurs in an outer diameter dimension of the wick.

Then, with these configurations, wicks, in which obtainment of an evaporator with poor performance due to collapse of pores in the vicinity of the outer peripheral surface of the wick and non-favorable contact of an outer surface of the wick with an inner surface of the casing of the evaporator can be suppressed, can be mass-produced in a stable manner.

However, in the wick described in JP2011-190996-A, the process of forming the grooves in both the inner peripheral surface and the outer peripheral surface of the wick becomes complicated, resulting in an increase in cost, and there is a possibility that desired cooling performance cannot be obtained depending on specifications (specifications and conditions at the time of manufacturing) of the manufactured wick.

Therefore, specifications (specifications and conditions at the time of manufacturing) of a wick enabling implementation of further improvement of the cooling performance of a cooler are studied for the wick 6 of the present embodiment.

Next, the wick 6 provided inside the heat receiver 7 (evaporator 2) of the loop heat pipe 1 of the present embodiment will be described in detail.

As described above, the wick 6 used for the loop heat pipe 1 according to the present embodiment is configured by porous rubber such as foamed silicone rubber that is the porous body. By configuring the wick 6 with the porous rubber as described above, higher elastic force than the elastic force of a porous resin can be obtained. Therefore, the adhesion of the wick 6 to the casing (heat receiver 7) of the evaporator 2 is increased.

With the configuration, the heat transfer efficiency from the casing of the evaporator 2 to the wick 6 can be favorably obtained, and the cooling performance of the loop heat pipe 1 is improved.

Further, as described above, securement of high adhesion and suppression of local collapse of holes of the wick 6 can be implemented by a measure of configuring the wick 6 with the porous rubber. Therefore, if post-processing of transport grooves (grooves) such as the grooves 10 for transporting the working fluid (evaporation refrigerant) can be omitted, the manufacturing cost can be further reduced.

Although various methods can be considered as a method for manufacturing the wick configured by an elastic porous body, that is, a porous elastic body, the porous body in the present embodiment can be obtained applying a technology proposed with water-foamed silicone rubber, for example.

Specifically, using a water-foamed silicone rubber composition, stirring is performed such that bubbles present in cross section obtained when a foam formed in a sampling manner is cut are present as follows. The stirring is performed such that bubbles present in cross section have a size in a range from 0.1 $\mu$m to 50 $\mu$m, both inclusive, and bubbles having a pore size from 5 $\mu$m to 10 $\mu$m, both inclusive, are most present.

More specifically, the above-described porous body is obtained by mixing a catalyst, a surfactant, and a crosslinking agent with commercially available two-component liquid silicone rubber. The liquid silicone rubber is mixed and stirred with a mixed solution obtained by mixing an additive, a filler, a dispersant, and the like in water (with an alcohol if required) to have viscosity equivalent to the viscosity of the liquid silicone rubber, to prepare an emulsion composition. The liquid silicone rubber favorably has specific gravity of 1.00 to 1.05 g/cm$^3$ in consideration of emulsifying properties with water.

Here, a blending ratio of the liquid silicone rubber and the mixed solution varies depending on porosity to be obtained. For example, when the blending ratio of the liquid silicone rubber and the mixed solution is set to 1:1, particulate water in the emulsion evaporates and becomes a void, so a foam having the porosity of 50% can be obtained.

For the emulsion, a homogenizer or a stirrer with ultrasonic treatment is used as required, and various stirring conditions such as stirring means, stirring time, and stirring speed (for example, 300 to 1500 rpm) are adjusted to obtain a bubble distribution that satisfies the above-described conditions.

Thereafter, the prepared emulsion composition is filled in a mold and heated to perform primary heating for curing silicone rubber without evaporating water in the emulsion composition.

Here, the primary heating is performed in the condition that a heating temperature is in a range of 80 to 130°C and a heating time is in a range of 30 to 120 minutes. The heating temperature is favorably 90 to 110°C and the heating time is favorably 60 to 90 minutes. Next, secondary heating is performed to remove moisture from the foam after the primary heating. The secondary heating is performed in the condition that the heating temperature is 150 to 300°C and the heating time is 1 to 24 hours. The heating temperature is favorably 200 to 250°C and the heating time is favorably 3 to 8 hours. By performing such secondary heating, the moisture is removed from the porous body, and bubbles are formed into a continuous bubble type to become a composite cell formed by spherical bubbles partially overlapping each other, and final cure of the silicone rubber is terminated.

Next, specifications (specifications and conditions at the time of manufacturing) of the cross section, which can be obtained by cutting the water-foamed silicone rubber as the porous body for which the final cure has been terminated, will be described in more detail.

Pore size peak

Since the porous body used for the wick 6 has the function to move the working fluid by the capillary force to drive the loop heat pipe 1, the pore size of the porous body is favorably small to obtain larger capillary force.

The pore size (pore radius of the wick: rwick) and capillary force (capillary pressure: $\Delta$Pcap) of the porous body used for the wick 6 are expressed using the following Equation 1.

$$\Delta Pcap = 2\sigma\cos\theta/rwick \;...\; (Equation\;1)$$

Here, $\sigma$ is surface tension of the working fluid, and $\theta$ is a contact angle between the wick and the working fluid.

As can be seen from Equation 1 above, the capillary pressure becomes larger as the pore radius of the wick is smaller. Further, to operate the loop heat pipe 1, the capillary force (capillary pressure: $\Delta Pcap$) and a total pressure loss: $\Delta Ptotal$ need to satisfy the following Inequality 2.

$$\Delta Pcap \geq \Delta Ptotal \;...\; (Inequality\;2)$$

Further, the total pressure loss: $\Delta Ptotal$ can then be obtained using Equation 3.

$$\Delta Ptotal = \Delta Pwick + \Delta Pgroov + \Delta PVL + \Delta Pcond + \Delta PLL + \Delta Pgrav \;...\; (Equation\;3)$$

Here, $\Delta Pwick$ is a pressure loss of the wick, $\Delta Pgroov$ is a pressure loss of the groove, $\Delta PVL$ is a pressure loss of the steam pipe, $\Delta Pcond$ is a pressure loss of the condenser, $\Delta PLL$ is a pressure loss of the liquid pipe, and $\Delta Pgrav$ is a pressure loss due to gravity.

As described above, to obtain larger capillary force, a pore size peak of the porous body is favorably smaller, is specifically favorably 50 $\mu$m or smaller. When the pore size peak is larger than 50 $\mu$m, obtainment of capillary force sufficient to drive the loop heat pipe is difficult. The pore size peak is favorably 30 $\mu$m or smaller, and more favorably 10 $\mu$m or smaller.

In a case where the thickness of the wick is extremely thin, the wick can be made to function even with the thickness of 1 $\mu$m or smaller or 0.1 $\mu$m or smaller, but a lower limit value is favorably 0.1 $\mu$m or larger.

Here, the pore size peak can be determined by capturing the cross section of the porous body with a laser microscope and measuring the area of the holes by image processing of an obtained image.

Porosity

Higher porosity of the porous body used for the wick 6 is more advantageous for driving the loop heat pipe 1. Specifically, the porosity of the porous body is favorably 20% or larger. When the porosity is less than 20%, driving of the loop heat pipe 1 becomes difficult. More favorably, the porosity is 50% or larger. The porosity can be calculated by the following Equation 4.

$$The\;porosity\;(\%) = (the\;specific\;gravity\;of\;the\;porous\;body\;-\;the\;specific\;gravity\;of\;solid)/(the\;specific\;gravity\;of\;solid) \times 100 \;...\; (Equation\;4)$$

Communication hole diameter

A communication hole of the wick 6 refers to a portion where bubbles (cells) communicate with each other and a portion where the capillary force for driving the working fluid acts. To obtain the cooling performance, the diameter of the communication hole (communication hole diameter) is favorably 10 $\mu$m or smaller, and more favorably 5 $\mu$m or smaller. Further, an average pore size of the communication holes is favorably set to 3 $\mu$m or smaller, so that the wick 6 itself can more favorably achieve both the high capillary force and permeability.

Note that, in a case where the thickness of the wick 6 is extremely thin, the communication hole can be made to function even with the diameter of 1 $\mu$m or smaller or 0.1 $\mu$m or smaller.

The diameter of the communication hole is measured by a bubble point method, and an obtained maximum pore size is adopted as the communication hole diameter.

Here, gas pressure is applied to the porous body completely immersed in a test solution, and the pressure at which appearance of bubbles is recognized is adopted as a bubble point. Moreover, the maximum pore size is calculated using the following Equation 5 using a test solution with known surface tension.

$$d = 4\sigma\cos\theta/\Delta P \;...\; Equation\;5$$

Here, d is the maximum pore size, σ is the surface tension of the working fluid, θ is the contact angle between the wick and the working fluid, and ΔP is the pressure loss.

Cooling performance test

Next, cooling performance tests performed by setting examples within main numerical ranges and comparative examples out of the numerical ranges, of the above-described conditions of the wick 6, will be appropriately described with reference to the drawings.

(1) Description of an electronic device (projector) 20 favorably provided with a wick used in a cooling performance test.

FIG. 4 is a schematic explanatory view illustrating another example of the loop heat pipe 1 provided in the electronic device 20 according to the present embodiment.

Further, another example of the loop heat pipe 1 illustrated in FIG. 4 is an example in which a wick slightly larger than an inner diameter of a cylindrical internal space of the casing (case) of the evaporator 2 is press-fitted into the casing of the evaporator, unlike the example illustrated in FIG. 1.

Note that, as the cooler of the electronic device according to the present embodiment, the loop heat pipe 1 illustrated in FIG. 1 can be used instead of the loop heat pipe illustrated in FIG. 4. However, the loop heat pipe illustrated in FIG. 4 is used for the cooling performance tests of the examples and comparative examples described below.

The electronic device 20 illustrated in FIG. 4 is a projector including an optical unit 21. The projector is an example of an electronic device to which the present embodiment is applied.

Here, the electronic device to which the loop heat pipe 1 according to the present embodiment can be applied is not limited to the projector. The loop heat pipe 1 can be applied to various electronic devices such as an image forming device such as a printer, a copier, a facsimile, or a multifunction peripheral of the aforementioned functions, a personal computer, a server, an electronic blackboard, a television, a Blu-ray recorder, and a game machine, in addition to the projector.

Further, the loop heat pipe 1 and the cooling device according to the present embodiment can be applied to devices other than the electronic devices. For example, the loop heat pipe 1 and the cooling device according to the present embodiment may be applied to a cooling device for cooling a chemical plant or the like equipped with a reaction furnace, or to a container or a building attached to an electronic device such as a server rack.

The evaporator 2 (in particular, the heat receiver 7) of the loop heat pipe 1 illustrated in FIG. 4 is disposed in contact with a heat generator of the optical unit 21. The evaporator 2 absorbs heat from the heat generator to cool the object to be cooled (heat generator, the optical unit, or the projector).

The condenser 3 is disposed in the vicinity of an exhaust fan 22 provided on a side surface of a casing of a projector main body. When the exhaust fan 22 discharges the air to the outside, an air flow is generated around the condenser 3, the condenser 3 is cooled by the air flow, and heat dissipation effect in the condenser 3 is improved.

Further, an air supply port 23 is provided in the side opposite to the side surface of the casing where the exhaust fan 22 is provided, and the air taken in through the air supply port 23 passes through the inside of the projector and is discharged from the exhaust fan 22. In the example illustrated in FIG. 4, the loop heat pipe 1 and the exhaust fan 22 for enhancing the heat dissipation effect of the loop heat pipe 1 are provided as a cooling device for cooling the projector. A blower fan for blowing the air to the condenser 3 may be provided instead of the exhaust fan 22. Further, a cooling device provided with the loop heat pipe 1 without the fan may be adopted.

(2) Detailed description of examples and comparative examples.

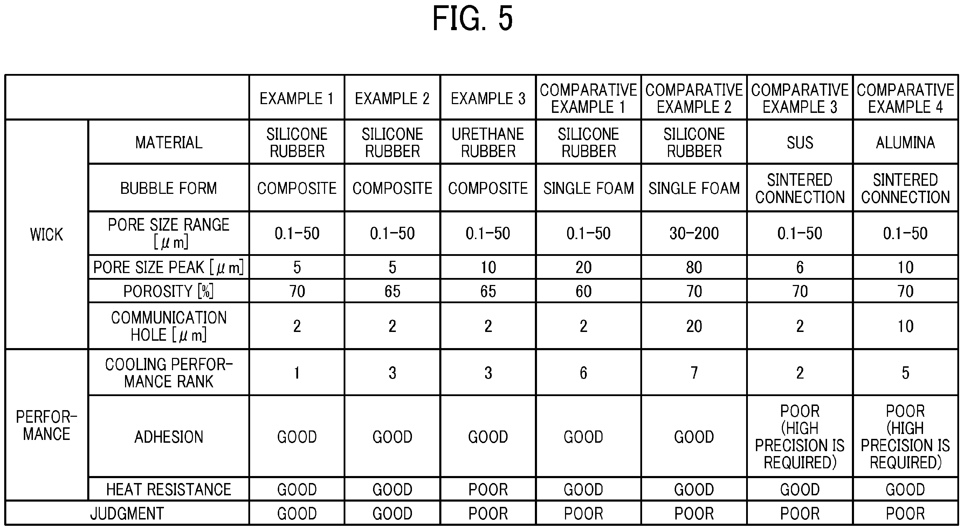

FIG. 5 is an explanatory diagram of specifications and test results of samples of examples and comparative examples used for cooling performance test.

In the present test, as illustrated in FIG. 5, a plurality of samples of the examples of the wick 6 was prepared with water-foamed silicone rubber, and samples of the comparative examples of the wick 6 were prepared with water-foamed silicone rubber, chemically-foamed silicone rubber, water-foamed urethane rubber, metal, and ceramic. Then, a cooling performance test by a single device in a case of using each prepared sample for the loop heat pipe 1 was performed.

Examples 1 and 2

In Examples 1 and 2, a water-foamed silicone rubber material with an activator and a polymer selected to be composite cell (composite) was used for both the examples, the amount of water was adjusted, and two types of Example 1 with the porosity of 70% and Example 2 with the porosity of 65% were prepared.

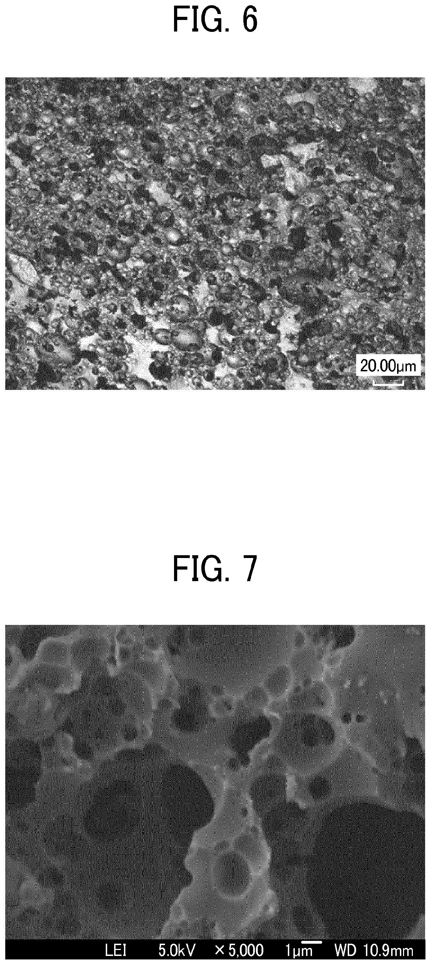

FIG. 6 is a view of the sample of the wick 6 of Example 1 in a bubble state observed (captured) with a laser microscope, and it can be confirmed that the bubbles are adjacent to each other and have a composite shape.

FIG. 7 is a view of bubbles of the sample of the wick 6 of Example 1 further enlarged and observed by a scanning electron microscope, and communication holes of 5 $\mu$m or smaller connecting the bubbles can be confirmed.

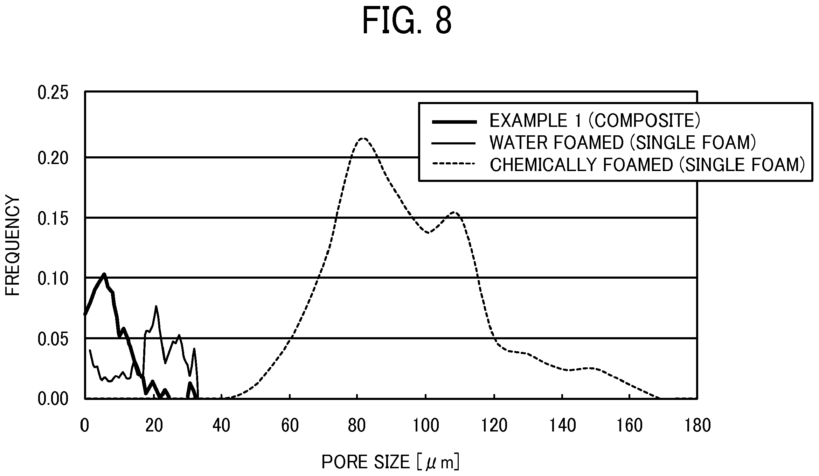

FIG. 8 is a graph illustrating results of measuring pore size distributions of representative samples of the wick 6 used in the examples and comparative examples used for the cooling performance test, and illustrates results after processing images of the representative samples with a laser microscope and measuring the pore size distributions.

Example 3

In Example 3, a water-foamed urethane rubber was used to obtain a composite cell (composite). The pore size range $\mu$m and the porosity % are equivalent to the case of using the water-foamed silicone rubber of Examples 1 and 2 and the cooling performance is ranked third but a heat resistance characteristic is up to about 120°C. For this reason, heat resistance was defect (poor) and cannot be used depending on a cooling application. Therefore, comprehensive judgment (judgment) was also defect (poor).

Here, as illustrated in FIG. 5, in Example 3, the pore size range $\mu$m of the sample was in the range from 0.1 $\mu$m to 50 $\mu$m, both inclusive, the peak of the pore size distribution of the sample (pore size peak $\mu$m) was 10 $\mu$m, and the communication hole diameter (communication hole $\mu$m) was 2 $\mu$m.

Since the wick 6 was configured by urethane rubber, high adhesion (good) was obtained by producing the wick 6 slightly larger than the inner dimension of the casing of the heat receiver 7 of the evaporator 2 using elasticity of the urethane rubber.

In the graph in FIG. 8, the thick solid line illustrates the distribution of the sample of Example 1 that is the composite cell, the thin solid line illustrates the distribution of the water-foamed silicone rubber of Comparative Example 1 that is a single foam (single cell), and the broken line illustrates the distribution of the chemically-foamed silicone rubber of Comparative Example 2 that is the single foam. Here, the distribution of the pore size $\mu$m is expressed by a probability density function and is in a relationship of probability density of a vertical axis Y to the pore size $\mu$m of a horizontal axis X. In image processing, the number (frequency) of bubbles in a certain pore size range $\mu$m is calculated like sieving. In all the bubbles present in an image processing range, the number (probability) of bubbles present in the certain pore size range $\mu$m is obtained.

As illustrated in FIG. 8, in the distribution of the sample of Example 1 that is the composite cell, the following facts can be confirmed, as compared with the distributions of the water-foamed silicone rubber of Comparative Example 1 and the chemically-foamed silicone rubber of Comparative Example 2 of other single foams. It can be confirmed that the distribution of the sample of Example 1 is a fine pore size distribution with the bubbles (pore size range) of a range from 0.1 $\mu$m to 50 $\mu$m, both inclusive, and the peak of the distribution of the sample of Example 1 is 5 $\mu$m.

Further, as illustrated in FIG. 5, in each of Examples 1 and 2, the pore size range $\mu$m of the sample was in the range from 0.1 $\mu$m to 50 $\mu$m, both inclusive, the peak of the pore size distribution of the sample (pore size peak $\mu$m) was 5 $\mu$m, and the communication hole diameter (communication hole $\mu$m) was 2 $\mu$m.

Although the water-foamed silicone rubber of Examples 1 and 2 causes a dehydration reaction of a water phase simultaneously with crosslinking of rubber at the time of secondary heating, the communication holes between bubbles are efficiently formed due to the composite cell, and both the permeability and expression of the capillary force by the fine communication holes can be achieved. Further, high adhesion (good) was obtained by producing the wick 6 to be slightly larger than the inner diameter of the casing (case) of the heat receiver 7 of the evaporator 2 using the elasticity of silicone rubber, and the cooling efficiency was improved. As a result, the cooling performance was very favorable both in Examples 1 and 2 and was particularly favorable in Example 1 with high porosity %, and Example 1 was ranked first and Example 2 was ranked third in the cooling performance, which are favorable, and it is considered that the difference in the permeability was exhibited in the performance.

Further, since the wick 6 was configured by silicone rubber, the heat resistance was also favorable (good), and the comprehensive judgment (judgment) was also favorable (good).

Here, as for Example 3 using the water-foamed urethane rubber material, the pore size range $\mu$m was in the range from 0.1 $\mu$m to 50 $\mu$m, both inclusive, the peak of the pore size distribution of the sample (pore size peak $\mu$m) was 10 $\mu$m, and the communication hole diameter (communication hole $\mu$m) was 2 $\mu$m. Therefore, similarly to Examples 1 and 2, Example 3 was also very favorable in the cooling performance and was ranked third in the cooling performance. However, as described above, the heat resistance was poor and becomes defect (poor) depending on a cooling application and cannot be used.

Comparative Example 1

In Comparative Example 1, a water-foamed silicone rubber material was used to obtain a single cell (single foam). The bubble have a size in a range from 0.1 $\mu$m to 50 $\mu$m, both inclusive, but the pore size peak is 20 $\mu$m, which is larger than the pore size peak in Examples 1 and 2. Because the material has a large pore diameter, the porosity can be increased up to 60%, and the cooling performance was worse than in Examples 1 and 2, and the cooling performance rank was ranked sixth, so the comprehensive judgment (judgment) was defect (poor).

Since the wick 6 was configured by silicone rubber, high adhesion (good) was obtained and the heat resistance was favorable (good) by producing the wick 6 slightly larger than the inner dimension of the casing of the heat receiver 7 of the evaporator 2 using elasticity of the silicone rubber.

Comparative Example 2

In Comparative Example 2, a chemically-foamed silicone rubber material was used to obtain a single cell (single foam). Since chemical foaming does not basically form a communication hole, bubbles were caused to communicate by being broken by being drawn with a metal roller. However, forming the fine communication hole is difficult by the foam breaking. As a result, the cooling performance was poor and the cooling performance was ranked seventh, and the comprehensive judgment (judgment) was defect (poor).

Further, as illustrated in FIG. 5, in Comparative Example 2, the pore size range $\mu$m was in a range from 30 $\mu$m to 200 $\mu$m, both inclusive, the peak of the pore size distribution of the sample (pore size peak $\mu$m) was 80 $\mu$m, the porosity was 70%, and the communication hole diameter (communication hole $\mu$m) was 2 $\mu$m.

Since the wick 6 was configured by silicone rubber, high adhesion (good) was obtained and the heat resistance was favorable (good) by producing the wick 6 slightly larger than the inner dimension of the casing of the heat receiver 7 of the evaporator 2 using elasticity of the silicone rubber.

Comparative Examples 3 and 4

In Comparative Examples 3 and 4, a metal (steel use stainless (SUS)) was used in Comparative Example 3 and a ceramic (alumina) was used in Comparative Example 4 to be sintered samples (sintered connection). By controlling sintering conditions and particle diameters, the pore size range $\mu$m is equivalent and the pore size peak and the porosity % are substantially equivalent to the case of using the water-foamed silicone rubber in Examples 1 and 2 and the case of using the water-foamed urethane rubber in Example 3.

However, since both the materials are hard, very high precision is required to obtain adhesion with the casing (adhesion was poor), so the comprehensive judgment (judgment) was also defect (poor). Further, the problem is that the unit price is high for mass production.

Further, an efficiency decrease due to heat leak occurs because of higher thermal conductivity than thermal conductivity of silicone rubber. Therefore, Comparative Example 3 was ranked second and Comparative Example 4 was ranked fifth in the cooling performance, and both Comparative Examples 3 and 4 were worse than Example 1 in the cooling performance.

Note that the metal (SUS) was used in Comparative Example 3 and the ceramic (alumina) was used in Comparative Example 4 so that the wicks 6 become the sintered samples. Therefore, the heat resistance was favorable (good).

Here, as illustrated in FIG. 5, in Comparative Examples 3 and 4, the pore size ranges $\mu$m of the samples were in the range from 0.1 $\mu$m to 50 $\mu$m, both inclusive, and the peak of the pore size distribution of the sample (pore size peak $\mu$m) was 6 $\mu$m in Comparative Example 3 and 10 $\mu$m in Comparative Example 4. Further, the porosity % was 70% both in Comparative Examples 3 and 4, and the communication hole diameter (communication hole $\mu$m) was 2 $\mu$m in Comparative Example 3 and 10 $\mu$m in Comparative Example 4.

From the results of the cooling performance test using the above-described samples of Examples 1 to 3 and Comparative Examples 1 to 4, the following effects have been able to be confirmed according to the specifications of the bubbles, the communication holes, and the like present in cross section obtained when the porous body configuring the wick 6 of the present embodiment was cut.

First Specifications: (Specifics of Examples 1, 2, and 3)

The bubbles present in cross section had a size in a range from 0.1 $\mu$m to 50 $\mu$m, both inclusive, the composite cells were present, and among the composite cells, bubbles having the pore size from 5 $\mu$m to 10 $\mu$m, both inclusive, were most present, and the communication holes of 5 $\mu$m or smaller were included between the bubbles.

Effects of Examples 1, 2, and 3

Further improvement of the cooling performance of the loop heat pipe 1 can be implemented. Specifically, the cooling performance was ranked first to third.

Here, one point of the single foam falls outside the first specifications in Comparative Example 1, and three points of the single foam, the pore size range of 30 to 200 $\mu$m, and the communication hole of exceeding 5 $\mu$m fall

outside the first specifications in Comparative Example 2. Comparative Example 1 was ranked sixth and Comparative Example 2 was ranked seventh in the cooling performance. Further, a point of the sintered connection of SUS (metal) falls outside the first specifications in Comparative Example 3 and the cooling performance was ranked second, and two points of the sintered connection of alumina (ceramic) and the communication hole of exceeding 5 um fall outside the first specifications in Comparative Example 4 and the cooling performance was ranked fifth.

From the comparison, it has been confirmed that the wick itself can more favorably achieve both the high capillary force and permeability because the cooling performance is ranked lower as the number of points falling outside the specifications satisfied by Examples 1 and 2 becomes larger, and the average pore size of the communication holes is 3 $\mu$m or smaller, except Comparative Example 3 using SUS.

Second Specifications: (Specifications of Examples 1 and 2 and Comparative Examples 1 and 2)

The porous body is configured by the foamed silicone rubber, specifically, by the water-foamed silicone rubber in Examples 1 and 2 and Comparative Example 1 and by the chemically-foamed silicone rubber in Comparative Example 2.

Effects of Examples 1 and 2 and Comparative Examples 1 and 2

The elasticity and heat resistance can be imparted to the wick 6.

Here, in Example 3, the porous body is configured by foamed urethane rubber (water-foamed urethane rubber) and the adhesion is improved by imparting the elasticity. However, as described above, the heat resistance characteristic is up to 120°C. Further, Comparative Example 3 is configured by the metal (SUS), and Comparative Example 4 is configured by the ceramic (alumina), and both have heat resistance but have poor elasticity, and require high precision processing to make the adhesion favorable, and are evaluated to be defective from the viewpoint of cost.

Third Specifications: (Specifications of Examples 1 and 2 and Comparative Example 1)

The porous body is configured by the water-foamed silicone rubber.

Effects of Examples 1 and 2 and Comparative Example 1

By changing the foamed silicone rubber to the water-foamed silicone rubber, both the fine pore size and favorable communication can be achieved.

Here, in Comparative Example 2, the porous body was configured by the chemically-foamed silicone rubber, and the pore diameter range was 30 to 200 $\mu$m, the pore size peak was 80$\mu$m, and the communication hole was 20 $\mu$m, and it has been found that both the fine pore size and favorable communication cannot be achieved.

As described above, it has been confirmed that Examples 1 and 2 satisfying all of the first specifications, the second specifications, and the third specifications have very favorable cooling performance, and can provide a cooling device including a roller achieving the adhesion and heat resistance to the casing.

Although the present embodiment has been described with reference to the drawings, the specific configuration is not limited to the configuration of the loop heat pipe 1 provided with the wick 6 of the above-described embodiment, and design change and the like not deviating from the gist may be made.

For example, in the loop heat pipe 1 of the present embodiment described with reference to FIGS. 1,2, and 4, the configuration provided with one evaporator 2 and one condenser 3 has been described. However, the configuration of the loop heat pipe of the present embodiment is not limited to such a configuration. The present embodiment is also applicable to a loop heat pipe provided with the evaporator 2 and the condenser 3, the number of at least one of which is two or more.

Further, in the loop heat pipe 1 of the present embodiment described with reference to FIGS. 1, 2, and 4, the configuration provided with one wick 6 inside the evaporator 2 has been described. However, the present embodiment is also applicable to a configuration provided with a plurality of wicks in parallel.

The above description is merely examples, and a specific effect is exerted in each of the following modes.

Aspect A

A wick such as the wick 6 configured by a porous body such as a porous elastic body used in a cooler such as the loop heat pipe 1 including an evaporator such as the evaporator 2 (heat receiver 7) that changes a working fluid such as a condensable fluid from a liquid phase to a gas phase and a condenser such as the condenser 3 that changes the working fluid from the gas phase to the liquid phase, and provided in the evaporator, in which a plurality of bubbles present in cross section obtained when the porous body is cut has sizes in a range from 0.1 μm to 50 μm, both inclusive, a plurality of composite cells formed by spherical bubbles partially overlapping each other is present, and among the plurality of composite cells, bubbles having pore sizes from 5 μm to 10 μm, both inclusive, are most present, and a plurality of communication holes of 5 μm or smaller is present between the bubbles.

According to this configuration, the following effects can be exerted.

The porous body configuring the wick of the present aspect is manufactured such that the bubbles and the communication holes present in a cross section obtained when the porous body is cut satisfy the above-described specifications, thus allowing the porous body itself to achieve both higher capillary force and higher permeability than before.

As described above, since the porous body itself configuring the wick can achieve both the higher capillary force and higher permeability than before, further improvement of cooling performance of the cooler can be implemented.

Therefore, the wick enabling implementation of further improvement of the cooling performance of the cooler can be provided.

Aspect B

In Aspect A, an average pore size of the communication holes is equal to or smaller than 3 μm.

According to this aspect, the wick itself can more favorably achieve both the high capillary force and high permeability.

Aspect C

In Aspect A or Aspect B, the porous body is made of foamed silicone rubber.

According to this aspect, configuring the porous body by foamed silicone rubber can impart elasticity and heat resistance.

Aspect D

In Aspect C, the foamed silicone rubber is water-foamed silicone rubber.

According to this aspect, configuring the foamed silicone rubber by water-foamed silicone rubber can achieve both a fine pore size and favorable communication.

Aspect E

A loop heat pipe such as the loop heat pipe 1 including an evaporator such as the evaporator 2 (heat receiver 7) that changes a working fluid such as a condensable fluid from a liquid phase to a gas phase and a condenser such as the condenser 3 that changes the working fluid from the gas phase to the liquid phase, in which the wick such as the wick 6 according to any one of Aspect A to Aspect D is provided inside the evaporator.

According to this aspect, the loop heat pipe implementing high cooling performance can be provided.

Aspect F

A cooling device such as a cooler of the electronic device (projector) 20 includes a loop heat pipe including an evaporator such as the evaporator 2 (heat receiver 7) that changes a working fluid such as a condensable fluid from a liquid phase to a gas phase and a condenser such as the condenser 3 that changes the working fluid from the gas phase to the liquid phase. In the cooling device, a loop heat pipe such as the loop heat pipe 1 according to Aspect E is used as the loop heat pipe.

According to this aspect, the cooling device having high cooling performance can be provided.

Aspect G

An electronic device including a cooler includes a loop heat pipe such as the loop heat pipe 1 of Aspect E as the cooler.

According to this aspect, the electronic device including required cooling performance can be provided.

Aspect H

A method not within the scope of the invention for manufacturing a porous body such as a porous elastic body used in a cooler such as the loop heat pipe 1 including an evaporator such as the evaporator 2 (heat receiver 7) that changes a working fluid such as a condensable fluid from a liquid phase to a gas phase and a condenser that changes the working fluid from the gas phase to the liquid phase, and provided in the evaporator. The method includes manufacturing the porous body such that a plurality of bubbles present in a cross section obtained when the porous body is cut has a size in a range from 0.1 $\mu$m to 50 $\mu$m, both inclusive, a plurality of composite cells formed by spherical bubbles partially overlapping each other is present, and among the plurality of composite cells, bubbles having a pore size from 5 $\mu$m to 10 $\mu$m, both inclusive, are most present, and a plurality of communication holes of 5 $\mu$m or smaller is present between the plurality of bubbles.

According to this configuration, the following effects can be exerted.

In the porous body manufacturing method according to the present aspect, the porous body is manufactured such that the bubbles and the communication holes present in cross section obtained when the manufactured porous body is cut satisfy the above-described specifications. Thus, the porous body that can achieve both higher capillary force and higher permeability than before can be manufactured.

As described above, since the porous body itself configuring the wick can achieve both the higher capillary force and higher permeability than before, further improvement of the cooling performance of the cooler using the wick configured by the porous body can be implemented.

Therefore, the porous body manufacturing method for manufacturing the porous body configuring the wick enabling implementation of further improvement of the cooling performance of the cooler can be provided.

Aspect I

A wick manufacturing method not within the scope of the invention for manufacturing a wick such as the wick 6 configured by a porous body such as a porous elastic body used in a cooler such as the loop heat pipe 1 including an evaporator such as the evaporator 2 (heat receiver 7) that changes a working fluid such as a condensable fluid from a liquid phase to a gas phase and a condenser such as the condenser 3 that changes the working fluid from the gas phase to the liquid phase, and provided in the evaporator. The method includes manufacturing the porous body such that a plurality of bubbles present in a cross section obtained when the porous body is cut has a size in a range from 0.1 $\mu$m to 50 $\mu$m, both inclusive, a plurality of composite cells formed by spherical bubbles partially overlapping each other is present, and among the plurality of composite cells, bubbles having a pore size from 5 $\mu$m to 10 $\mu$m, both inclusive, are most present, and a plurality of communication holes of 5 $\mu$m or smaller is present between the plurality of bubbles.

According to this configuration, the following effects can be exerted.

The wick manufactured by the wick manufacturing method of the present aspect is manufactured such that the bubbles and the communication holes present in cross section obtained when the porous body configuring the wick is cut satisfy the above-described specifications. Thus, the manufactured wick itself can achieve both the higher capillary force and higher permeability than before.

As described above, since the wick itself thus manufactured can achieve both the higher capillary force and higher permeability than before, further improvement of the cooling performance of the cooler using the wick can be implemented.

Therefore, the wick manufacturing method for manufacturing the wick enabling implementation of further improvement of the cooling performance of the cooler can be provided.

**Claims**

1.   A wick (6) comprising a porous body,
     the porous body including:

          a plurality of bubbles having sizes in a range from 0.1 $\mu$m to 50 $\mu$m, both inclusive, in a cross section obtained when the porous body is cut; **characterised in that** the porous body further includes
          a plurality of composite cells formed by spherical bubbles partially overlapping each other, bubbles of pore sizes from 5 $\mu$m to 10 $\mu$m, both inclusive, being most present among the plurality of composite cells; and
          a plurality of communication holes of 5 $\mu$m or smaller between the plurality of bubbles.

2.   The wick (6) according to claim 1,
     wherein an average pore size of the plurality of communication holes is equal to or smaller than 3 $\mu$m.

3.   The wick (6) according to claim 1 or 2,
     wherein the porous body includes foamed silicone rubber.

**4.** The wick (6) according to claim 3,
wherein the foamed silicone rubber is water-foamed silicone rubber.

**5.** A loop heat pipe (1) comprising:

an evaporator (2) configured to change a working fluid from a liquid phase to a gas phase;
a condenser (3) configured to change the working fluid from the gas phase to the liquid phase; and
the wick (6) according to any one of claims 1 to 4 disposed inside the evaporator (2).

**6.** A cooling device comprising the loop heat pipe (1) according to claim 5.

**7.** An electronic device (20) comprising the loop heat pipe (1) according to claim 5 as a cooler (1).

**Patentansprüche**

**1.** Docht (6), der einen porösen Körper umfasst,
wobei der poröse Körper Folgendes umfasst:

eine Vielzahl von Blasen mit Größen in einem Bereich von 0,1 $\mu$m bis 50 $\mu$m, jeweils einschließlich, in einem Querschnitt, der erhalten wird, wenn der poröse Körper geschnitten wird; **dadurch gekennzeichnet, dass** der poröse Körper ferner Folgendes umfasst:
eine Vielzahl von zusammengesetzten Zellen, die durch kugelförmige Blasen gebildet werden, die sich teilweise überlappen, wobei Blasen mit Porengrößen von 5 $\mu$m bis 10 $\mu$m, jeweils einschließlich, am meisten unter der Vielzahl von zusammengesetzten Zellen vorhanden sind; und
eine Vielzahl von Verbindungslöchern von 5 $\mu$m oder weniger zwischen der Vielzahl von Blasen.

**2.** Docht (6) nach Anspruch 1,
wobei eine durchschnittliche Porengröße der Vielzahl von Verbindungslöchern gleich oder kleiner als 3 $\mu$m ist.

**3.** Docht (6) nach Anspruch 1 oder 2,
wobei der poröse Körper geschäumten Silikonkautschuk umfasst.

**4.** Docht (6) nach Anspruch 3,
wobei der geschäumte Silikonkautschuk ein wassergeschäumter Silikonkautschuk ist.

**5.** Kreislaufwärmerohr (1), das Folgendes umfasst:

einen Verdampfer (2), der dafür konfiguriert ist, ein Arbeitsfluid von einer flüssigen Phase in eine Gasphase zu überführen;
einen Kondensator (3), der dafür konfiguriert ist, das Arbeitsfluid von der Gasphase in die flüssige Phase zu überführen; und
den Docht (6) nach einem der Ansprüche 1 bis 4, der im Inneren des Verdampfers (2) angeordnet ist.

**6.** Kühlvorrichtung, die das Kreislaufwärmerohr (1) nach Anspruch 5 umfasst.

**7.** Elektronische Vorrichtung (20), die das Kreislaufwärmerohr (1) nach Anspruch 5 als Kühler (1) umfasst.

**Revendications**

**1.** Mèche (6) comprenant un corps poreux,
le corps poreux comprenant :

une pluralité de bulles ayant des tailles dans une plage de 0,1 $\mu$m à 50 $\mu$m, toutes deux incluses, dans une section transversale obtenue lorsque le corps poreux est coupé ; **caractérisé en ce que** le corps poreux comprend en outre
une pluralité de cellules composites formées par des bulles sphériques se chevauchant partiellement, des bulles de tailles de pores de 5 $\mu$m à 10 $\mu$m, toutes deux incluses, étant les plus présentes parmi la pluralité de cellules composites ; et
une pluralité de trous de communication de 5 $\mu$m ou moins entre la pluralité de bulles.

2. Mèche (6) selon la revendication 1,
dans laquelle une taille moyenne de pores de la pluralité de trous de communication est égale ou inférieure à 3 $\mu$m.

3. Mèche (6) selon la revendication 1 ou 2,
dans laquelle le corps poreux comprend du caoutchouc de silicone expansé.

4. Mèche (6) selon la revendication 3,
dans laquelle le caoutchouc de silicone expansé est du caoutchouc de silicone expansé dans l'eau.

5. Caloduc à boucle (1) comprenant :

un évaporateur (2) configuré pour faire passer un fluide de travail d'une phase liquide à une phase gazeuse ;
un condenseur (3) configuré pour faire passer le fluide de travail de la phase gazeuse à la phase liquide ; et
la mèche (6) selon l'une quelconque des revendications 1 à 4 disposée à l'intérieur de l'évaporateur (2).

6. Dispositif de refroidissement comprenant le caloduc à boucle (1) selon la revendication 5.

7. Dispositif électronique (20) comprenant le caloduc à boucle (1) selon la revendication 5 en tant que refroidisseur (1).

# FIG. 1

# FIG. 2

# FIG. 3

# FIG. 4

# FIG. 5

| | | EXAMPLE 1 | EXAMPLE 2 | EXAMPLE 3 | COMPARATIVE EXAMPLE 1 | COMPARATIVE EXAMPLE 2 | COMPARATIVE EXAMPLE 3 | COMPARATIVE EXAMPLE 4 |
|---|---|---|---|---|---|---|---|---|
| WICK | MATERIAL | SILICONE RUBBER | SILICONE RUBBER | URETHANE RUBBER | SILICONE RUBBER | SILICONE RUBBER | SUS | ALUMINA |
| | BUBBLE FORM | COMPOSITE | COMPOSITE | COMPOSITE | SINGLE FOAM | SINGLE FOAM | SINTERED CONNECTION | SINTERED CONNECTION |
| | PORE SIZE RANGE [$\mu$m] | 0.1–50 | 0.1–50 | 0.1–50 | 0.1–50 | 30–200 | 0.1–50 | 0.1–50 |
| | PORE SIZE PEAK [$\mu$m] | 5 | 5 | 10 | 20 | 80 | 6 | 10 |
| | POROSITY [%] | 70 | 65 | 65 | 60 | 70 | 70 | 70 |
| | COMMUNICATION HOLE [$\mu$m] | 2 | 2 | 2 | 2 | 20 | 2 | 10 |
| PERFOR-MANCE | COOLING PERFOR-MANCE RANK | 1 | 3 | 3 | 6 | 7 | 2 | 5 |
| | ADHESION | GOOD | GOOD | GOOD | GOOD | GOOD | POOR (HIGH PRECISION IS REQUIRED) | POOR (HIGH PRECISION IS REQUIRED) |
| | HEAT RESISTANCE | GOOD | GOOD | POOR | GOOD | GOOD | GOOD | GOOD |
| JUDGMENT | | GOOD | GOOD | POOR | POOR | POOR | POOR | POOR |

# FIG. 6

# FIG. 7

EP 3 605 004 B1

# FIG. 8

**EP 3 605 004 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018109497 A
- JP 2003148887 A
- JP 2011247462 A
- JP 5699452 B
- JP 2011190996 A